# EUROPEAN PATENT SPECIFICATION

(11) **EP 2 061 069 B1**
(45) Date of publication and mention of the grant of the patent: **02.03.2011**
(21) Application number: 08017552.4
(22) Date of filing: 07.10.2008
(51) Int. Cl.: H01K 9/00, H01K 1/14, H01L 21/00

(54) **Filament lamp and heat treatment device of the light irradiation type**
Glühlampe und lichtausstrahlende Wärmebehandlungsvorrichtung
Lampe à incandescence et dispositif de traitement thermique à irradiation lumineuse

(30) Priority: 10.10.2007 JP 2007264137
(43) Date of publication of application: 20.05.2009
(73) Proprietor: USHIODENKI KABUSHIKI KAISHA, Chiyoda-ku 100 Tokyo (JP)
(72) Inventor: Tanino, Kenji, Himeji-shi Hyogo-ken (JP); Mizukawa, Yoichi, Himeji-shi Hyogo-ken (JP); Suzuki, Shinji, Himeji-shi Hyogo-ken (JP)
(74) Representative: Tomerius, Isabel

(56) References cited:
- EP-A- 1 249 856
- US-A- 3 073 986
- US-A1- 2006 197 454

## Description

### Background of the Invention

### Field of Invention

The present invention pertains to heat treatment devices of the light irradiation type in which filament lamps are supplied with electrical power independently and many such filament lamps are arranged in parallel.

### Description of Related Art

Generally, in semiconductor manufacturing processes, a silicon oxide film is formed, and by means of a wide variety of processes, including the diffusion of impurities, requiring rapid heat treatments or the uniform heating of an article to be treated.

Japanese Unexamined Patent Application Publication 2006-279008 and corresponding U.S. Patent Application Publication 2006/197454 describe a heat treatment device of the light irradiation type that is configured as follows. In order to heat an article to be treated by light emitted from filaments, multiple filament lamps are equipped with coiled filaments having differing overall lengths that are arranged in individual light-emitting tubes and the filaments are arranged to conform to the shape of the article to be treated, forming a surface light source.

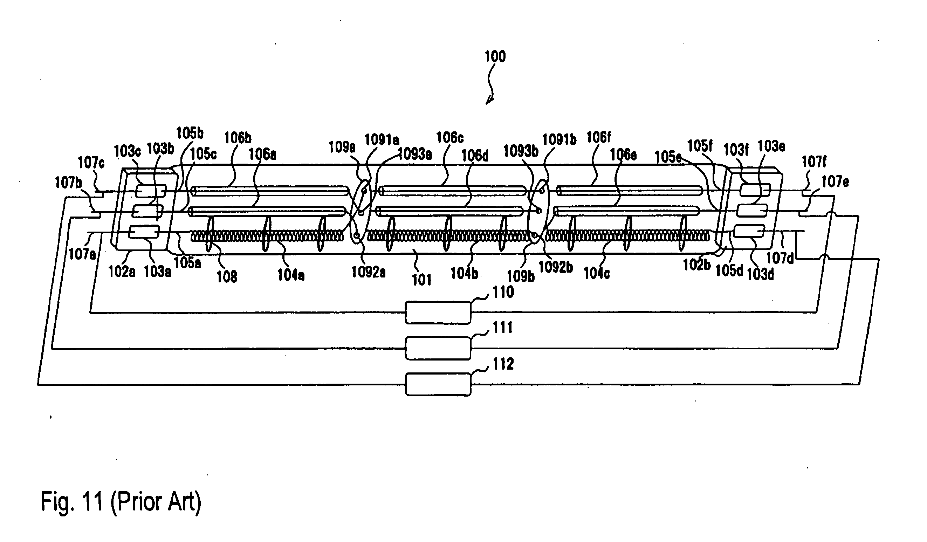

Figure 11 is a perspective view showing the configuration of a filament lamp with multiple filaments arranged inside the light-emitting tube described in the cited Japanese Unexamined Patent Application Publication 2006-279008 and corresponding U.S. Patent Application Publication 2006/197454, and controllable electrical power can be supplied to these multiple individual filaments.

As shown in the diagram, the hermetically sealed portions 102a, 102b, in which metal foils 103a, 103b, 103c, 103d, 103e, 103f have been embedded, are formed at both ends of the light-emitting tube 101 of the filament lamp 100. Placed inside the light-emitting tube 101, are three filament modules, which are composed of coiled filaments 104a, 104b, 104c as well as leads 105a, 105b, 105c, 105d, 105e, 105f, for supplying electrical power to the filaments 104a, 104b, 104c. Here, when multiple filament modules are arranged in the light-emitting tube 101, each filament module is configured so that the filaments 104a, 104b, 104c are arranged sequentially along the length of the light-emitting tube 101.

Lead 105a, which is connected to one end of the first filament 104a, which is located on the left, inside the light-emitting tube 101, is electrically connected to the metal foil 103a, which is embedded in the hermetically sealed portion 102a at one end of the light-emitting tube 101. Also, the lead 105f, which is connected to the other end of the first filament 104a, is electrically connected to the metal foil 103f, which is embedded in the hermetically sealed portion 102b at the other end of the light-emitting tube 101 through the through-hole 1091b of the insulator 109b and the insulating tube 106c, which is located opposite the filament 104b of the other filament module and the through-hole 1091a of the insulator 109a and the insulating tube 106f, which is located opposite the filament 104c of the other filament module.

The lead 105c, which is connected to one end of the second filament 104b, which is located in the center of the interior of the light-emitting tube 101, is electrically connected to the metal foil 103b, which is embedded in the hermetically sealed portion 102a at one end of the light-emitting tube 101 through the insulating tube 106a, located opposite the filament 104a of the other filament module and the through-hole 1092a of the insulator 109a. Also, the lead 105e, which is connected to the other end of the second filament 104b is electrically connected to the metal foil 103e, which is embedded in the hermetically sealed portion 102b at the other end of the light-emitting tube 101 through the insulating tube 106e, located opposite the filament 104c of the other filament module and the through-hole 1092b of the insulator 109b.

The lead 105b, which is connected to one end of the third filament 104c, which is located on the right, interior of the light-emitting tube 101, is electrically connected to the metal foil 103c, which is embedded in the hermetically sealed portion 102a at one end of the light-emitting tube 101 through the through-hole 1093b of the insulator 109b and the insulating tube 106d, which is placed opposite the filament 104b of the other filament module, and the through-hole 1093a of the insulator 109a, through the insulating tube 106b, which is placed opposite the filament 104a of the other filament module. The lead 105d, which is connected to the other end of the third filament 104a, is electrically connected to the metal foil 103d, which is embedded in the hermetically sealed portion 102b at the other end of the light-emitting tube 101.

Also, at the end opposite the end where the leads 105a, 105b, 105c, 105d, 105e, 105f of the filament modules are connected to the metal foils 103a, 103b, 103c, 103d, 103e, 103f that are sealed inside the modules 102a, 102b, the external leads 107a, 107b, 107c, 107d, 107e, 107f are connected so that they project outward from the hermetically sealed portions 102a, 102b. Thus, the pairs of external leads 107a, 107b, 107c, 107d, 107e, 107f corresponding to each of the filament modules, are connected to the filament modules through the metal foil 103a, 103b, 103c, 103d, 103e, 103f. The power supply devices 110, 111, 112 are connected to each of the filaments 104a, 104b and 104c via the external leads 107a, 107b, 107c, 107d 107e, 107f. In this way, it makes it possible for the filament lamp 100 to supply electrical power individually to the filaments, 104a, 104b, 104c, in each of the filament modules.

Note also that each of the filaments 104a, 104b, 104c is supported so that it does not come into contact with the light-emitting tube 101 using ring-shaped anchors 108, which are placed so that they enclose them between the inside wall of the light-emitting tube 101 and the insulating tubes 106a, 106b, 106c, 106d, 106e, 106f. Here, if the filaments 104a, 104b, 104c come into contact with the inside wall of the light-emitting tube 101 when the filaments 104a, 104b, 104c are producing light, the transmittance of the light-emitting tube 101 will be lost where contact is made because the heat of the filaments 104a, 104b, 104c would devitrify the light-emitting tube 101. The anchors 108 prevent this sort of problem. Several anchors 108 are placed on each of the filaments 104a, 104b, 104c, lengthwise along the light-emitting tube 101. Also, when manufacturing the filament lamp 100, the anchors 108 are given a degree of elasticity so that multiple filament modules can be easily inserted into the interior of the light-emitting tube 101. Also, a gap of some degree is provided so that there is space between the anchors 108 and the interior wall of the light-emitting tube 101 and the insulating tubes 106a, 106b, 106c, 106d, 106e, 106f.

Because the filament lamp 100 does not supply electricity to the filaments 104a, 104b, 104c with a single power supply and is capable of supplying electricity to each of the filaments 104a, 104b, 104c with the respective power supplies 110, 111, 112, it makes it possible to adjust the distribution of the light beam so that the temperature distribution will be uniform and to achieve high-speed and uniform heating will be achieved.

At the same time, when heat-treating a semiconductor wafer (silicon wafer) to 1050 °C or higher, when there is non-uniform distribution of heat on the semiconductor wafer, the semiconductor wafer will undergo a phenomenon known as "slip." In other words, there would be a risk of defects in the crystal transition, leading to defective items. For that reason, when using a light-beam heat treatment device to subject a semiconductor wafer or similar article to RTP (rapid thermal processing), it is necessary to use heating, maintenance of high temperatures and cooling so that the temperature will be uniformly distributed over the entire surface of the article to be treated and articles subject to RTP require a high degree of precision uniformity of temperature. In order to achieve this sort of rapid heat treatment, the heat treatment device of the light irradiation type is configured in this manner. Multiple filament lamps contain coiled filaments of differing lengths inside individual light-emitting tubes and the filaments are conformed to the shape of the article to be treated forming a surface light source and the article to be treated is heated by emitting light from each of the filaments at the article to be treated.

In other words, in order to heat the article to be treated so that the temperature distribution at the surface of the article to be treated is uniform, the power density (power level applied per unit of filament length) is adjusted so that the power density applied to the filament corresponding to a zone that is closer to the peripheral edge than the center of the article to be treated is greater than that at the center of the article to be treated. More specifically, the rated power density at the filament placed in the zone corresponding to the peripheral edge of the article to be treated is made larger than the rated power density of the filament placed in the zone corresponding to the center of the article to be treated. For example, if the filament lamp 100 shown in Figure 11 were used, the power density of the filaments 104a, 104c corresponding to the peripheral edge of the article to be treated could be made higher than that of the filament 104b corresponding to the center of the article to be treated in order to heat the article to be treated uniformly.

However, even when using the filament lamp 100 that has multiple filaments with independent power supplies like the one shown in Figure 11, there are times when the uniform heating of a semiconductor wafer or other article to be treated is impossible. In other words, when the weight per unit of length of each of the filaments that is supplied power independently and the surface area are identical, it was learned that if the power density per unit of length of the filaments 104a, 104c corresponding to the peripheral area of the article to be treated is made higher than that of the filament 104b corresponding to the center area for heating the article to be treated uniformly, the spectra of the light emitted by the filaments 104a, 104c corresponding to the peripheral area will be closer to the shorter wavelengths than the filament 104b corresponding to the center area of the article to be treated and the energy ratio on the shorter wavelength side will occupy a greater portion of the overall irradiance.

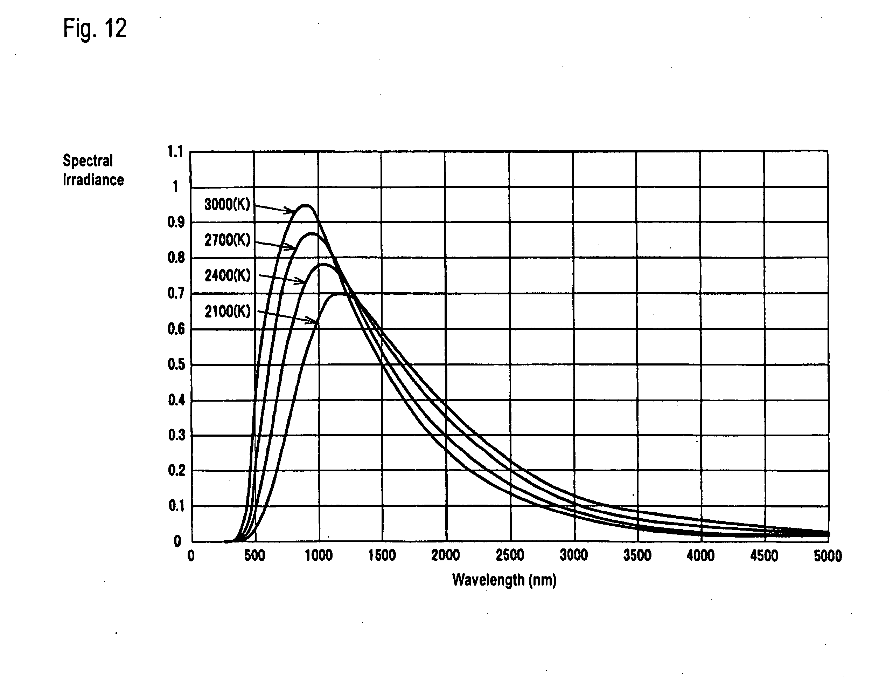

Figure 12 is a graph comparing the spectral irradiance when the total irradiance is made identical (equivalent to making the power density identical) and that graph indicates that, even if the total energy emitted is the same, if the color temperature (in other words, the surface temperature of the filaments) is different, then the spectral irradiance seen at each wavelength will be different. Note also that the term "color temperature" is something that expresses the color of light at the temperature of a black body. When the filaments are made of the same material (tungsten, in this example), the surface temperature of the filament and the color temperature of the light from the filament are in a 1 to 1 correspondence and the relationship between the surface temperature and the color temperature of the light emitted from the surface can be calculated in advance so that the color temperature of the light can be measured and substituted for the surface temperature of the filament without any problem.

In other words, when the weight of the filament per unit of length and the surface area are identical, if the power density of the electrical power supplied per unit of length of the filament is high, then the temperature of the filament will rise, and if the power density of the electrical power supplied is low, the temperature of the filament will fall. As is clear from this chart, as the temperature rises or falls, a phenomenon occurs in which the wavelength of the light that is emitted from that filament shifts toward the shorter wavelengths when, for example, the power density is increased and the filament temperature increases.

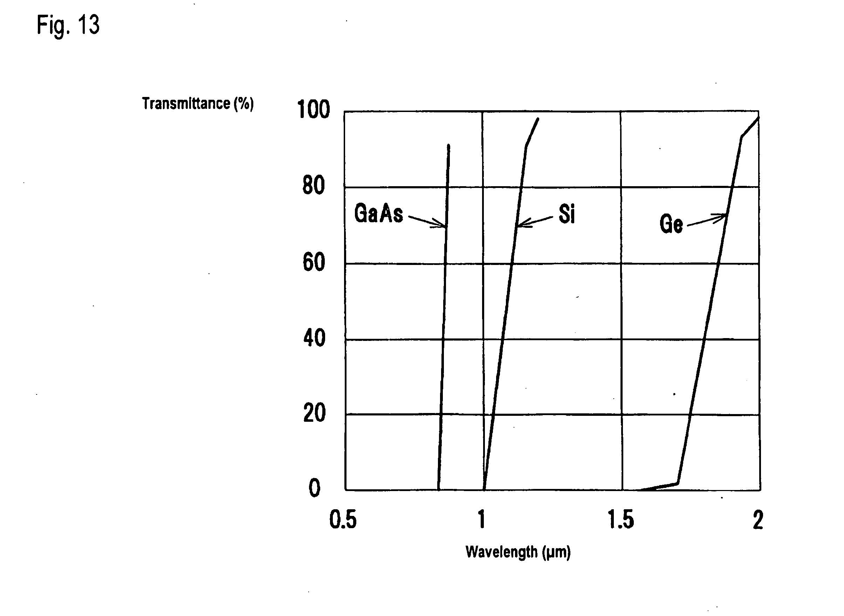

Figure 13 is a graph showing the transmittance at each of the wavelengths of Si, GaAs and Ge. The vertical axis indicates the transmittance of the light (%) and the horizontal axis shows the wavelength (µm) of the light.

It is known that Si has photoabsorption characteristics (transmittance with respect to the wavelength of the light) in which the transmittance of such an article would change rapidly from 0 % to 100 % going from 1 µm to 1.2 µm, as indicated by this graph. In other words, it can be seen that Si strongly absorbs light with a wavelength of 1 µm or less while allowing nearly all light with a wavelength greater than 1.1 µm to pass through.

It follows that, when the article to be treated is Si, when the irradiance of light at wavelengths greater than 1.1 µm from the filament corresponding to the center area of the article to be treated is strong, and when the irradiance of light at wavelengths of 1.1 µm or less from the filament corresponding to the peripheral edge of the article to be treated is strong, then the ratio of the thermal dose to the ratio of the power density per unit of length of the filament corresponding to the center area of the article to be treated and the power density per unit of length of the filament corresponding to the peripheral edge of the article to be treated will not be in a proportional relationship. In other words, because the wavelengths of the light being emitted are different, there would be a lot of light passing through and little being absorbed for the center area of the article to be treated so that it would heat up gradually, but the peripheral edge of the article to be treated would have little light that passed through and much would be absorbed, so that it would heat up rapidly. This would cause a temperature difference to occur between the center area and the peripheral edge of the article to be treated, making it impossible to heat the article uniformly.

### Summary of the Invention

Based on the problems described above, a primary object of the present invention which is defined by the claims is to provide a heat treatment device of the light irradiation type that has filament lamps that are supplied with electrical power independently and uses filament lamps with filament coils that can be set to a specific temperature.

The present invention employs the following means for solving the problems described above.

In a first aspect, the filament lamps are configured with multiple filament modules with light-emitting tubes that contain hermetically sealed portions formed at opposite ends thereof, and on both ends of the coiled filaments is a respective pair of connected leads that supplies electrical power to the filament, and these filament modules are arranged so that they extend along the axis of the light-emitting tubes and the respective leads are electrically connected to a respective electrically conductive component placed inside the hermetically sealed portions. At least one of the individual filaments described above is made up of a single wire and at least two filaments are made up of bundled wires and the at least one filament made of the single wire described above is placed between the ones with the bundled wires described above.

The second aspect relates to a filament lamp with the features of the first means in which the bundled wires described above are twisted.

The third aspect relates to a filament lamp with the features of the first means in which the bundled wires described above are made up of two to four bare wires.

The fourth aspect relates to a heat treatment device of the light irradiation type with multiple units of the filament lamps described in any one of the above noted three aspects that are arranged in parallel.

With this invention, some of the filaments in the filament lamp are bundled wires which makes it possible to increase the surface area of the filament per unit of length. This can occur, for example, when using filaments that have identical weights per unit of length, in other words, when the electrical resistance values are equivalent, the surface area of the filaments made from bundled wires will be greater than the surface area of the filaments made from single wires. The energy emitted from the unit length of the filament is the value of the energy emitted from the unit surface area of the filament times the surface area per unit of filament length. Meanwhile, the energy emitted from the unit surface area of the filament changes due to the surface temperature of the filament and is known to be proportional to the fourth power of the temperature, based on the Stefan-Boltzmann law. Because the energy emitted from the unit length of the filament is nearly equivalent to the power density that is applied to the filament (there will be differences caused by heat escaping through thermal transmission from the filaments to the leads or power loss through the resistance of such connectors between the filaments and the leads), the temperatures of the filaments (in other words, the color temperature of the light emitted from the filaments) corresponding to the center area of the article to be treated and the filament corresponding to the peripheral edge of the article to be treated can be made essentially the same by making the power density ratio the same as the surface area ratio.

Here, using bundled wires and adjusting the number of bare wires, the electrical resistance of the filaments can be adjusted to nearly any level, so that problems like the filaments becoming too thick and coming into contact with the light-emitting tube or the rigidity of the filament falling to the point that the coils cannot be held in place can be avoided and the desired power density can be engineered.

Also, with this invention, by twisting the bundled wires into twisted wires, it is possible to increase the length of the bare wires per unit of filament length in comparison with the bare wires that are simply bundled together, making it possible to increase the electrical resistance of the filament and raise the power density, broadening the freedom of design to allow the accommodation of a variety of article to be treated. Furthermore, the rigidity of the filaments can be improved by using fine, bare wires, which makes it possible to avoid the problem of filaments deforming under their own weight. Also, when five or more bundled wires are used, the peripheral area increases in opposition to the other bundled wires and the surface area grows smaller with respect to the weight per unit of filament length. For this reason, using two to four bundled wires makes it possible to avoid increases to an undesired length while increasing the surface area very efficiently while avoiding an undesired decline in electrical resistance while preventing deformation of the filament under its own weight.

Furthermore, by having the same color temperature for the light that is emitted from each of the filaments arranged around the peripheral edge zone of the article to be treated and each of the filaments arranged around the center zone of the article to be treated (in other words, having the surface temperature of the filaments be the same), it is possible to make the spectra of the light that is radiated to the article to be treated identical, and to make the light absorption over the entire area of the article to be treated uniform.

Additionally, by using a heat treatment device of the light irradiation type in which multiple filament lamps have been arranged in parallel, it is possible to achieve rapid and uniform heating of the article to be treated.

### Brief Description of the Drawings

Figure 1 is a cross-sectional view of the heat treatment device of the light irradiation type of the present invention configured with independently powered multiple filament lamps arranged in parallel.

Figure 2 is a diagram looking at the article to be treated through the multiple filament lamps that have been arranged in parallel from above the surface of the drawing of the heat treatment device of the light irradiation type 2 in Figure 1.

Figure 3 is a perspective view showing the configuration of the filament lamp using the heat treatment device of the light irradiation type shown in Figure 1.

Figure 4 is a partially enlarged view of the filaments shown in Figure 3.

Figure 5 is an enlarged view of the connection area seen from the surface of the drawing in (a) and (b) is an enlarged view of the side of the connection area for the internal leads shown in Figure 3.

Figure 6 is an enlarged view of the connection area for the internal leads shown in Figure 3 in a different configuration with the connection area in Figure 5.

Figure 7 is a partially enlarged view of filaments which are configured differently from the filaments in Figure 4 and which are made up of bundled wires.

Figure 8, (a) is a cross-sectional view of the filaments showing a suitable number of bare wires making up the filaments, which are made up of the bundled wires shown in Figure 3, and for comparison, and (b) is a cross-section diagram of the filaments showing an inappropriate number of bare wires making up the filaments, which are made up of the bundled wires shown in Figure 3.

Figure 9 is a diagram looking at the article to be treated from the second lamp unit, in which the first lamp unit shown in Figure 2 has been omitted.

Figure 10 is a diagram of an alternative to the arrangement of Figure 9, from which the first lamp unit shown in Figure 2 has been omitted and which shows the configuration of the second lamp unit, looking at the article to be treated from the second lamp unit where the article to be treated has been divided into a Zone Y1 corresponding to the peripheral edge of the article to be treated, a Zone Y2, corresponding to the intermediate area and Zone Y3 corresponding to the central area.

Figure 11 is a perspective view showing a filament configuration to which electric power can be supplied that is controlled to each of the filaments in which multiple filaments have been arranged in a light-emitting tube involving conventional technology.

Figure 12 is a graph comparing the spectral irradiance when the total irradiance is the same (when the power density has been made equivalent).

Figure 13 is a graph showing the permeability at each wavelength of Si, GaAs and Ge.

### Detailed Description of the Invention

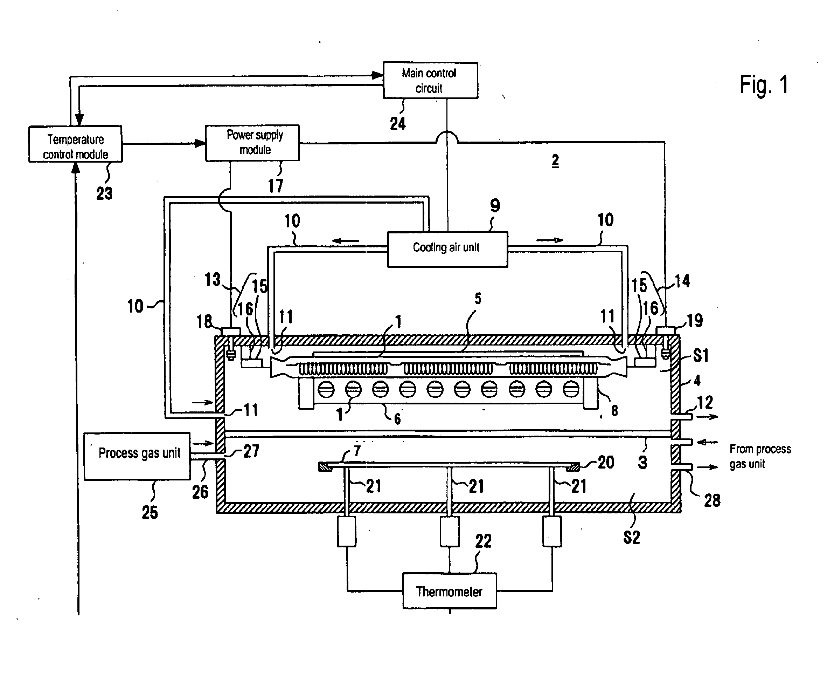

An embodiment of the present invention will now be explained using Figures 1 through 10.

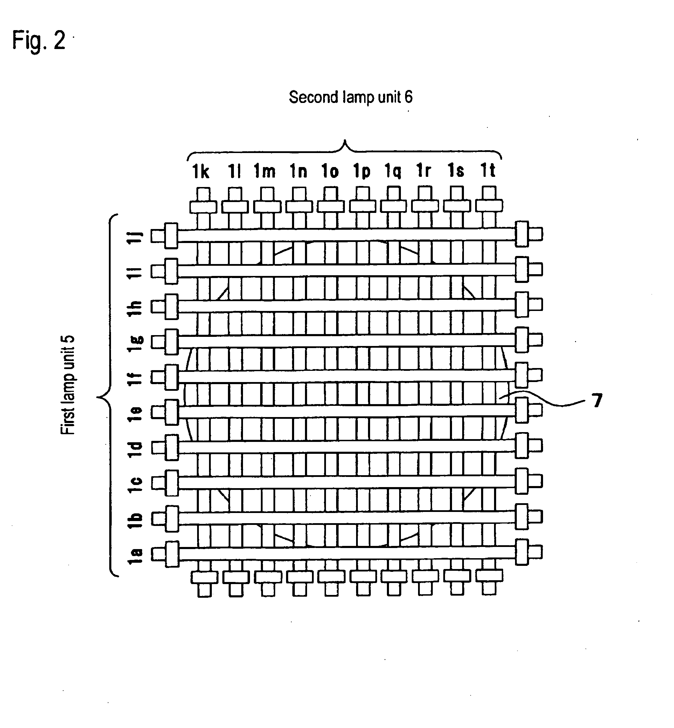

Figure 1 is a cross-section diagram of a heat treatment device of the light irradiation type according to an embodiment of the invention, configured with multiple filament lamps that have independent power supplies and are arranged in parallel. Figure 2 is a diagram of the article to be treated looking at it from above the heat treatment device of the light irradiation type shown in Figure 1, through the multiple filament lamps arranged in parallel.

As shown in Figure 1, this heat treatment device of the light irradiation type 2 has a chamber that is divided into a lamp unit housing space S 1 and a heat-treatment space S2 using a transparent quartz window 2, a quartz glass window for example. The light emitted from the first lamp unit 5 and the second lamp unit 6 that are arranged in the lamp unit housing space S1 passes through the quartz window 3 and performs the heat treatment of the article to be treated 7 by striking the article to be treated 7 that has been placed in the heat-treatment space S2.

The first lamp unit 5 and the second lamp unit 6 housed in the lamp unit housing space S1 could be configured with 10 individual filament lamps 1 arranged in parallel at specific intervals. As shown in Figure 2, the filament lamps 1 making up the first lamp unit 5 are arranged so that the direction of the axes of the tubes cross at right angles, the direction of the axes of the tubes of the filament lamps 1 making up the second lamp unit 6. Note also that it is not always necessary to configure the device with two lamp units and it would be possible to configure one with just a single lamp unit.

The reflectors 8 are arranged off to the side of the first lamp unit 5 (toward the top of Figure 1) and around the four sides of the lamp units 5 and 6 (to the left and right of Figure 1). The reflectors 8 could be configured using a core material of oxygen-free copper coated with gold and the cross sections of the reflectors 8 are shaped like circle segments, ellipse segments, parabola segments, flat, etc. The reflectors 8 face upward from the first lamp unit 5 and the second lamp unit 6, reflecting the emitted light toward the article to be treated 7. In other words, the light that radiates from the first lamp unit 5 and the second lamp unit 6 either strikes the article to be treated 7 directly or is reflected at it by the reflectors 8.

In the lamp unit housing space S1, forced cooling air from the cooling air unit 9 is guided into the cooling air supply nozzle 10 from the injection port 11. The forced cooling air that is guided into the lamp unit housing space S 1 is blown against each of the filament lamps 1 in the first lamp unit 5 and the second lamp unit 6, cooling the light-emitting tubes of the respective filament lamps 1. Here, the hermetically sealed portion of each filament lamp 1 has a low thermal resistance compared with other points. For this reason, it would be desirable to arrange the injection port 11 of the cooling air supply nozzle 10 so that it faces the hermetically sealed portion of the filament lamps 1 and that the hermetically sealed portions of each of the filament lamps 1 be given first priority at cooling.

The cooling air that is blown against the filament lamps 1 and heated up very hot by heat exchange emerges from the cooling air exhaust port 12, which is located in the chamber 4. Note also that the flow of the cooling air must be taken into consideration so that the cooling air that has been heated to a high temperature in the heat exchange not conversely heat the filament lamps 1. The flow of the cooling air is set so that it will also cool the reflectors 8 simultaneously. Note also that if the reflectors 8 are to be cooled with water, using a water-cooled mechanism not shown in the figure, then it would not necessarily be required that the airflow be adjusted to cooling the reflectors 8 simultaneously.

However, the radiant heat from the heated article to be treated 7 will generate stored heat in the quartz window 3 and the thermal radiation that is emitted secondarily from the quartz window 3 in which heat is stored can subject the article to be treated 7 to undesirable heating effects. In this instance, the redundancy of the temperature control characteristics of the article to be treated 7 (for example, overshooting the temperature of the article to be treated 7 and having it higher than the set temperature) or variation in the temperature of the heat-storing quartz window 3 itself could degrade the temperature uniformity in the article to be treated 7. Also, it makes it more difficult to improve the cooling speed of the article to be treated 7. So, in order to control these problems, it is desirable that the injection port 11 of the cooling air supply nozzle 10 be placed close to the quartz window 3 as shown in Figure 1 and the forced cooling air from the cooling air unit 9 be set to cool the quartz window 3.

Each of the filament lamps 1 in the first lamp unit 5 is supported by a pair of first fixed supports 13 and 14. The first fixed supports 13 and 14 are made out of an electrically conductive support 15, which is made with an electrically conductive material, and a holder 16, which is made out of ceramic or other insulating material. The holder 16 is attached to an inside wall of the chamber 4 and it holds the electrically conductive support 15. If we take the number of filament lamps 1 constituting the first lamp unit 5 as n1 and the number of filaments in the filament lamps 1 as m1, then n1 x m1 would constitute one set. The filament lamps 1 of the second lamp unit 6 are held by second fixed supports, which are not shown in the drawing. Like the first fixed supports 13 and 14, the second fixed supports are made up of electrically conductive supports and holders not shown in the drawing. If we take the number of filament lamps 1 constituting the second lamp unit 6 as n2 and the number of filaments in the filament lamps 1 as m2, then n2 x m2 would constitute one set.

The chamber 4 has a pair of power supply ports 18 and 19, to which the power supply lines are connected from the power supply device of the power supply module 17. Note also that in Figure 1, one set of power supply ports 18 and 19 is shown, but the number of sets of power supply ports will be determined by the number of filaments in each of the filament lamps 1 and the number of filament lamps 1. In Figure 1, the power supply ports 18 and 19 are electrically connected to the electrically conductive supports 15 of the first lamp fixed supports 13 and 14. The electrically conductive supports 15 of the first lamp fixed supports 13 and 14 could be electrically connected to an external lead. This sort of configuration makes it possible to supply electrical power to the filaments of one of the filament lamps 1 in the first lamp unit 5. Note also that other pairs of power supply ports are used to make electrical connections to the other filaments of the filament lamp 1, the filaments of the other filament lamps 1 in the first lamp unit 5 and the filaments in each of the filament lamps 1 of the second lamp unit 6.

Also, a support device 20, on which the article to be treated 7 is fixed, is located in the heat-treatment space S2. For example, if the article to be treated 7 is a semiconductor wafer, it would be desirable to have the support device 20 be a plate or ring-shaped piece made of molybdenum, tungsten, tantalum or other metal with a high melting point, silicon carbide (SiC) or other ceramic material or quartz or silicon (Si) and that the inside circumference of the rounded opening have a guard ring that forms a ledge that will support the semiconductor wafer. The semiconductor wafer is placed so that it fits snugly into the rounded opening of the ring-shaped guard ring and the article to be treated 7, which is a semiconductor wafer, is supported by the ledge described above. The support device 20 itself reaches a high temperature due to the light beams and the peripheral edge of the facing semiconductor wafer is subject to supplementary radiant heating and it offsets the heat emitted away from the peripheral edge of the semiconductor wafer. This makes it possible to control the temperature loss caused by thermal radiation away from the peripheral edge of the semiconductor wafer.

On the opposite side of the article 7 that will be exposed to the light beams, which is placed on the support device 20, is a temperature measuring module 21 that is located close to the article to be treated 7. The temperature measuring module 21 is used to monitor the temperature distribution of the article to be treated 7 and a number of the temperature measuring modules 21, corresponding to the dimensions of the article to be treated 7, will be used. Thermocouples, radiant-heat meters or similar devices could be used as the temperature measuring module 21. The temperature data monitored using the temperature measuring module 21 is sent to the thermometer 22. Along with calculating the temperature at the measuring point on each of the temperature measuring modules 21 based on the temperature data sent by each of the temperature measuring modules 21, the thermometer 22 sends the calculated temperature data to the main control module 24 via the temperature control module 23. Based on the temperature data at each of the measuring points on the article to be treated 7, the main control module 24 sends commands to the temperature control module 23 to keep the temperature on the article to be treated 7 uniform and at the specified temperature. Based on these commands, the temperature control module 23 controls the electrical power supplied to the filaments of each of the filament lamps 1 from the power supply module 17. When the main control module 24 receives temperature data from the temperature control module 23 saying that the temperature at one of the measuring points is lower than the specified temperature, it will send out a command to the temperature control module 23 to increase the amount of power supplied to the filament coil in question so that the amount of light emitted from the light emitting module of the filament is close to the measuring point in question. Based on the command sent from the main control module 24, the temperature control module 23 will increase the electrical power supplied to the power supply ports 18 and 19, which are connected to the filament in question from the power supply module 17. Note also that temperature control by the temperature control module 23 is for fine-tuning a particular temperature range and is not intended to adjust large power differences like power ratios between the filaments corresponding to the center area of the article to be treated 7 described below and the filaments corresponding to the peripheral edge.

By sending out commands to the air-cooling unit 9 while the filament lamps in the first and second lamp units 5 and 6 are turned on, the main control module 24 controls so that the light-emitting tube and quartz window 3 do not go into a high-temperature state. Also, depending upon the type of heating process, the process gas unit 25, which feeds in and discharges the process gas, could also be connected to the heat-treatment space S2. For example, when running a thermal oxidation process, the process gas unit 25 could be connected to feed oxygen gas into the heat-treatment space S2 and then to purge the heat-treatment space S2 with a purge gas (such as nitrogen gas). The process gas and purge gas from the process gas unit 25 are fed into the heat-treatment space S2 from the injection port 27 of the gas supply nozzle 26, which is located in the chamber 4. Also, the exhaust gases are discharged from the exhaust port 28.

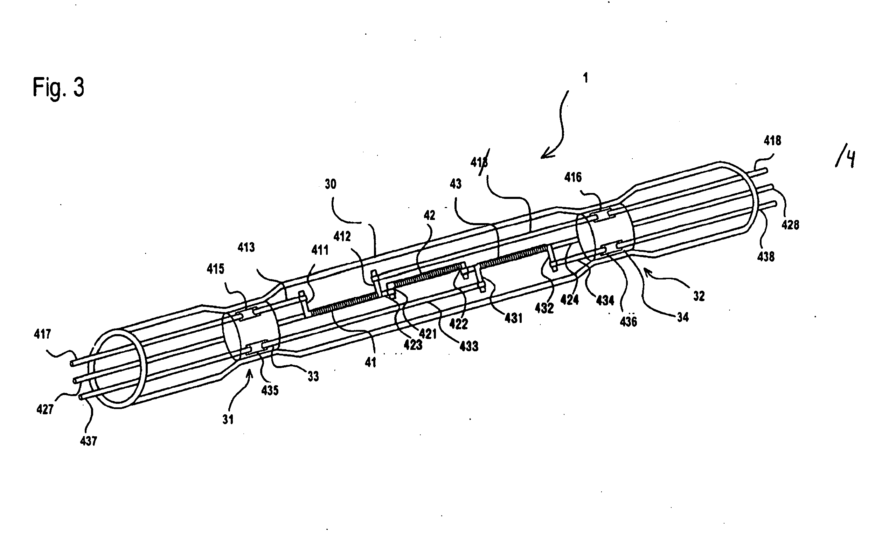

Figure 3 is an oblique view showing the configuration of the filament lamp 1 using the heat treatment device of the light irradiation type 2 shown in Figure 1.

As shown in that figure, the filament lamp 1 could be equipped with a straight tube light-emitting tube 30 made from quartz glass or a similar type of transparent material, air-tight seals are made on the hermetically sealed portions 31 and 32 by fusing the columnar sealing insulators 33 and 34 to the light-emitting tube 30 at both ends of the light-emitting tube 30. Halogen gas is sealed inside the light-emitting tube 30 and the filament modules, containing the coiled filaments 41, 42 and 43, are arranged sequentially in parallel along the axial direction of the light-emitting tube 30.

The rod-shaped internal leads 413, 423, 433, 414, 424 and 434 are electrically connected to both ends of the respective filaments, 41, 42 and 43. The internal leads 413, 423, 433, 414, 424 and 434 are placed along the axial direction of the light-emitting tube 30, embedded in the hermetically sealed portions 31 and 32 and connected to the metal foils 415 and 416, 435 and 436 as well as 425 and 426 (not shown), which are made from molybdenum, for example. The external leads 417, 418, 427, 428, 437 and 438 are designed so that they project from the ends of the hermetically sealed portions 31 and 32 and are electrically connected to the metal foils 415, 416, 435 and 436 as well as 425, 426 (not shown).

The filament modules are made up of the coil-shaped wrapped filaments 41, 42 and 43 that extend along the axial direction of the tube and the leads 411, 412, 421, 422, 431 and 432 are connected to both ends of the filaments 41, 42 and 43. Each of the leads 411, 412, 421, 422, 431 and 432 is connected to the ends of the filaments 41, 42 and 43, extending at right angles to the axis of the tube and connected to the internal leads 413, 423, 433, 414, 424 and 434. The number of such filament modules can be adjusted appropriately in response to the dimensions or physical properties of the article to be treated.

In each of the filament modules, the individual filaments 41, 42 and 43 are attached so that they are located along the central axis of the light-emitting tube 30. More specifically, inside the light-emitting tube 30, each of the filaments 41, 42 and 43 is supported so that it will not come into contact with the interior wall of the light-emitting tube 30 by means of ring-shaped anchors (not shown) that are placed so that they will press against the interior wall of the light-emitting tube 30. The use of anchors of this sort makes is possible to prevent the occurrence of problems such as the devitrification of the light-emitting tube 30 caused when any of the filaments 41, 42 and 43 come into contact with the interior wall of the light-emitting tube 30 under high-temperature conditions when light is being produced.

The hermetically sealed portions 31 and 32 formed on both ends of the light-emitting tube 30 could be configured as follows: The quartz glass columnar sealing insulators 33 and 34 are placed inside the light-emitting tube 30, the interior of the light-emitting tube 30 is evacuated and then the peripheral surface of the light-emitting tube 30 is heated with a burner or the like, causing it to shrink so that the outside diameter is smaller than the other places. On the outside surface of each of the sealing insulators 33 and 34 could be, for example, three metal foil pieces 415, 425 (not shown) and 435 as well as 416, 426 (not shown) and 436, each having the same number of filament modules and arranged at basically regular intervals in parallel and lengthwise along the sealing insulators 33 and 34. In order to keep the metal foil pieces 415, 416, 425 (not shown), 426 (not shown), 435 and 436 from bending, the units used should be shorter than the overall length of the sealing insulators 33 and 34 along the axis of the tube. Additionally, because each of the filaments 41, 42 and 43 is supplied with electrical power independently, each of the metal foil pieces 415, 416, 425 (not shown), 426 (not shown), 435 and 436 are arranged so that they are isolated electrically.

In the hermetically sealed portions 31 and 32, each of the internal leads 413, 414, 423, 424, 433 and 434 is connected to the leads, 411, 412, 421, 422, 431 and 432 on each of the filament modules and the external leads 417, 418, 427, 428, 437 and 438 are connected to each power supply device (not shown), and connected to the metal foil pieces 415, 416, 425 (not shown), 426 (not shown), 435 and 436 and fixed in place. The base end of each of the internal leads 413, 414, 423, 424, 433 and 434 is embedded in the hermetically sealed portions 31 and 32 and connected to the tips of the metal foils 415, 416, 425 (not shown), 426 (not shown), 435 and 436 by means of welding, for example, and the tips that project into the light-emitting tube 30 could be connected to each of the leads 411, 412, 421, 422, 431 and 432 by means of welding, for example. The tip of each of the external leads 417, 418, 427, 428, 437 and 438 is embedded in the hermetically sealed portions 31 and 32 and is connected to the base end of the hermetically sealed portions 31 and 32 by means of welding, for example and the base end projects outside the axis of the tube from outside the light-emitting tube 30. Note also that the internal leads 413, 414, 423, 424, 433 and 434 and the metal foil pieces 415, 416, 425 (not shown), 426 (not shown), 435 and 436 and the external leads 417, 418, 427, 428, 437 and 438 are made of electrically conductive material.

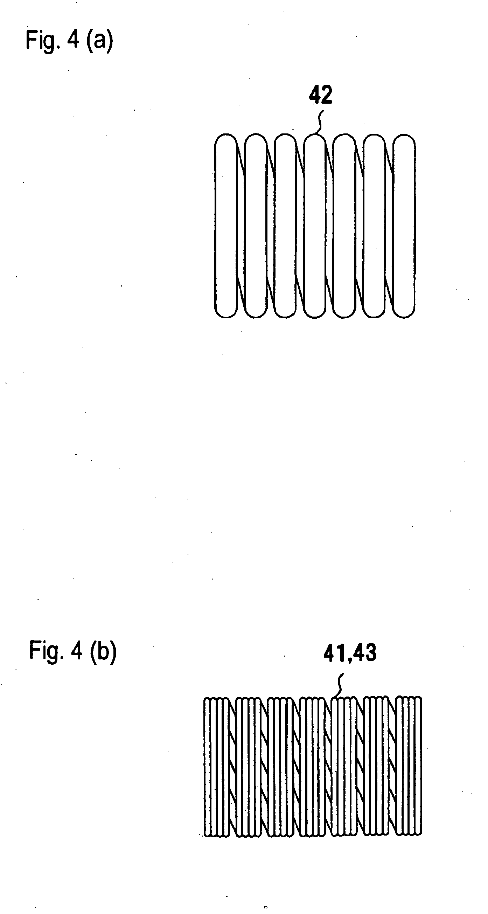

Figure 4(a) is a partial enlargement of the filament 42 shown in Figure 3. Figure 4(b) is a partial enlargement of the filaments 41, 43 shown in Figure 3.

The filaments 41, 43, which are located at both ends of the light-emitting tube 30 of the filament lamps 1 shown in Figure 3 consist of several single bare wires (four wires, for example) grouped into a bundled wire and wrapped into a coil, as shown in Figure 4(b). Also, as shown in Figure 4(a), along with being located in the center area of the light-emitting tube 30, the filament 42, is arranged with a single wire wrapped into a coil between the filament 41 and the filament 43, which are made up of bundled wires.

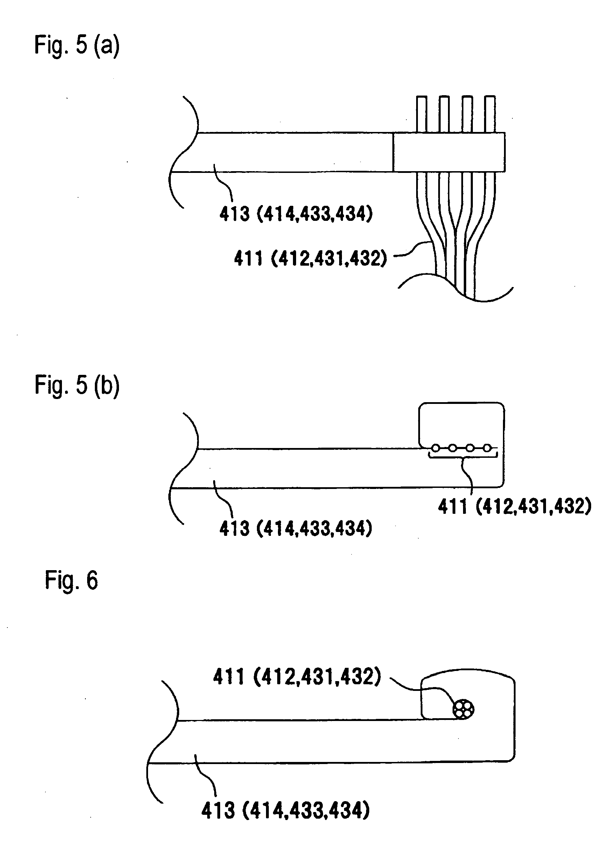

Figure 5(a) is an enlarged side-view, of the connectors of the internal leads 413, 414, 433 and 434 and the leads 411, 412, 431 and 432 shown in Figure 3. Figure 5(b) is a diagram showing the connection area shown in Figure 5(a) viewed from the underneath. As shown in Figures 5(a) and (b) the leads 411, 412, 431 and 432 and the internal leads 413, 414, 433 and 434 that are connected to the filaments 41, 43, which are made up of bundled wires, are electrically connected by folding the internal leads 413, 414, 433 and 434 back on themselves and crimping both ends of the leads 411, 412, 431 and 432. In the connection modules between the leads 411, 412, 431, 432 and the internal leads 413, 414, 433 and 434, as shown in Figures 5(a) and (b) the bundled wires that make up the leads 411, 412, 431 and 432 are divided up and multiple (such as four) bare wires are crimped onto the respective internal leads 413, 414, 433 and 434.

Figure 6 is an enlarged view of the connection area of the leads 411, 412, 431 and 432 and the connection area of the internal leads 413, 414, 433 and 434 shown in Figure 3, whose configuration differs from the connection areas in Figure 5.

Instead of the configuration for the connection areas shown in Figures 5(a) and (b), it would be possible to electrically connect the leads 411, 412, 431 and 432 of the filaments 41, 43, which are made up of bundled wires, with the internal leads 412, 414, 433 and 434 by crimping them to the internal leads 413, 414, 433 and 434 while they were still bundled as shown in Figure 6.

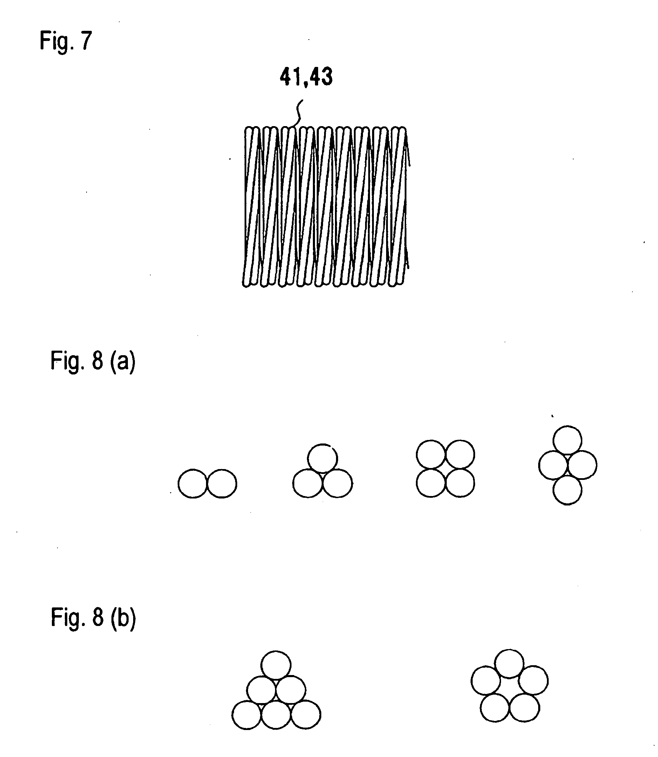

Figure 7 is a partially enlarged view of the filaments 41, 43 that differ from the configuration for the filaments 41, 43, which are made from the bundled wires shown in Figure 4(b).

In place of the bundled wire configuration shown in Figure 4(b) it would be possible to use twisted wires for the filaments 41, 43 made up of bundled wires, as shown in Figure 7. In other words, for the filaments 41, 43, the bundled wires that have bare wires arranged in parallel have been made with twisted wires that are twisted so that they will curl and these twisted wires are then wrapped into coils. Compared with simple, bundled bare wires, the twisted bundled wires, the bare wire length can be made longer per unit of filament length so that the electrical resistance of the filament and the power density can be increased, making is possible to accommodate a variety of process articles with a wide amount of design freedom. Also, the rigidity of the filaments can be improved even when fine bare wires are used, so it would also be possible to avoid problems associated with the deformation of filaments under their own weight.

Also, as shown in Figure 7, when using twisted bundled wires for the filaments 41, 43, the surface area per unit of length can be increased for the filaments 41, 43. For example, when the weights per unit of length of the filaments 41, 42, 43 are identical, the filaments 41, 43 the surface area of the filaments 41, 43 that are made of twisted bundled wires can be made even larger than the surface area of the filament 42, which is made from a single wire.

In other words, the filament lamp 1, where the surface area per unit of length of the filaments 41, 43, which are made from twisted bundled wires, is larger than the surface area per unit of length of the filament 42, which is made from a single wire, the rated power density per unit of length will be larger for the filaments 41, 43, which are made from bundled wires than for the filament 42, which is made from a single wire, and it will be possible to bring into close proximity, the temperature (in other words, the color temperature of the light emitted from the filament 42) of filament 42 made from a single wire and the filaments 41, 43, which are made from twisted bundled wires (in other words, the color temperature of the light emitted from the filaments 41, 43). At the same time, it will be possible to bring into close proximity the spectra of the light that is emitted from the filaments 41, 42, 43, which are composed of either single wires or bundled wires.

Figure 8(a) is a cross-section diagram of the filaments 41, 43 showing suitable numbers of bare wires that make up the filaments 41, 43, which are made up of the bundled wires shown in Figure 3. Figure 8(b) is a cross-section diagram of the filaments 41, 43 showing inappropriate numbers of wires for the bare wires making up the filaments 41, 43, which are composed of the bundled wires shown in Figure 3 for comparison with Figure 8(a).

As shown in Figure 8(a), it is possible to favorably increase the surface area of the filament surface facing the interior wall of the light-emitting tube 30 with respect to the weight per unit of filament length by configuring the bundled wires using 2 to 4 bare wires. As shown in the comparison example Figure 8(b), this is due to the fact that when five or more bare wires are bundled together, the opposed surface area between the bare wires increases, so the surface area facing the interior wall of the light-emitting tube 30 would become smaller than the two-to-four bundled wires in relation to the weight per unit of length. In other words, when the surface area facing the interior wall of the light-emitting tube 30 of filament lamp 1, with five or more bundled bare wires and that of filament lamp 1 with two to four bundled wires are made the same, the filament lamp 1 with five or more wires bundled together would end up having more weight per unit of length. When the weight per unit of length is larger, there is a risk that the filaments 41, 43 will deform under their own weight.

Also, an increase in the weight per unit of filament length signifies an increase in the total cross-section surface area of the filament wire, which will reduce the electrical resistance per unit of filament length. Because the lower electrical resistance will see greater current flow when the power densities are the same, if the weights are excessively large, a great deal of current will flow to the filaments, causing an amount of current that exceeds the rated value to flow through the metal foil in the hermetically sealed portions in the lamp, which could cause problems like shorter service life or open circuits. For this reason, it is possible to favorably increase the irradiance that radiates from the units of filament length when the filaments 41, 43 are burning, in addition to preventing an undesirable loss of resistance and deformation of the filaments 41, 43 by bundling two-to-four bare wires in the filaments 41, 43 made from bundled wires.

In other words, when bundled wires with five or more bare wires are used, the opposed peripheral area between the bare wires increases, reducing the surface area in relation to the weight per unit of length lower in the filaments 41, 43, so that by using just two to four bare wires in the bundled wires, it is possible to avoid an undesirable increase in the weight of the filaments 41, 43 and to prevent an undesirable loss of resistance in the filaments and avoid deformation under their own weight.

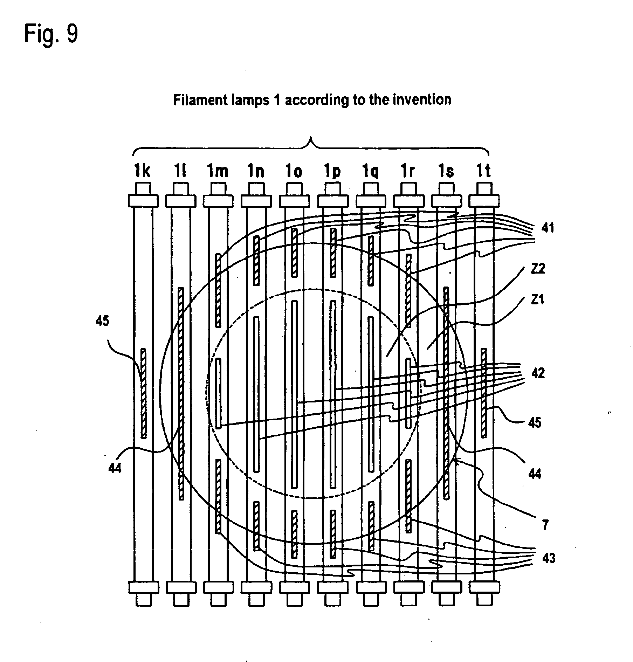

Figure 9 shows a view of the article to be treated 7 from the second lamp unit 6 with the first lamp unit 5 shown in Figure 2 left out.

In the heat treatment device of the light irradiation type 2 of the present invention, when the article to be treated 7 is subjected to heat treatment, the article to be treated 7 is divided into a zone corresponding to the peripheral edge of the article to be treated (ring-shaped zone) Z1 and a zone corresponding to the center area of the article to be treated 7 (circular zone) Z2 and, in order to obtain the specified temperature distribution in the article to be treated 7, the lighting of each of the filament lamps 1k through 1t in each of the zones Z1, Z2 is controlled. The filament lamp 1 pertaining to the present invention is used for the filament lamps 1m through 1r in each of the zones Z1, Z2. In other words, the filaments 41, 43, which are made of bundled wires of the filament lamp 1 shown in Figure 3, are placed in the peripheral edge zone Z1, and the filament 42 made of a single wire is placed in the center zone Z2.

If light is emitted with uniform irradiance over the entire surface of the article to be treated 7, the temperature of the peripheral area of the article to be treated 7 will fall below that of the center area because of heat radiation caused by radiation from the edge surface. For this reason, the peripheral edge zone Z1 needs to emit with greater irradiance than the center area zone Z2. Therefore, electrical power is supplied to the filaments 41, 43 that are made up of bundled wires so that their power density per unit of length will be greater than that of the filament 42, which is made up of a single wire.

Because the surface area per unit of length of the filaments 41, 43, which are made up of bundled wires, will be greater than that of the filament 42, which is made up of a single wire, the irradiance that is emitted from the unit of filament length from the filaments 41, 43 that are made up of bundled wires at the same filament temperature, will be larger than the irradiance that is emitted from the unit per filament length of the filament 42, which is made up of a single wire. By setting the surface area per unit of filament length larger so that it will offset the declines in temperature caused by radiant heat from the edge surface of the article to be treated 7, the temperature of the filament 42, which is made up of a single wire (in other words, the color temperature of the color emitted from the filament 42) and the temperature of the filaments 41, 43, which are made up of bundled wires (in other words, the color temperature of the light emitted from the filaments 41, 43) can be brought into closer proximity, making it possible to approximate the spectra of the light being emitted. At this point, the irradiance emitted per unit of filament length from the filaments 41, 43, which are made up of.bundled wires will be greater than the irradiance from the filament 42, which is made up of single wire, making it possible to heat the peripheral edge of the article to be treated 7, where the filaments 41, 43 have been placed that are made up of bundled wires, with a greater irradiance than the center area. This makes it possible to heat the article to be treated 7 so that its entire surface reaches a uniform temperature.

Further, by forming the filaments 41, 43 that heat the peripheral edge area of the article to be treated 7 using bundled wires, it is possible to make the surface area larger even without increasing the inside diameter of the coil making up the bundled wires, so that the inside diameter light-emitting tube 30 need not be increased undesirably. This allows the filament lamps 1 shown in Figure 2 to be placed in close proximity to each other, allowing the irradiance to be increased and achieving rapid heating of the article to be treated 7.

In Figure 1, when the filament lamps 1 are turned on, the main control module 24 uses the temperature data at each of the measuring points on the article to be treated 7 that is obtained from the thermometer 22 and sends commands to the temperature control module 23 so that the temperature at the surface of the article to be treated 7 will remain uniform and at the specified temperature. More specifically, in order to keep the temperature of the center area and the peripheral area of the article to be treated 7 uniform, that article is divided into two zones, Z1, Z2, and the amount of power supplied to each of the filaments in those zones is fine-tuned. The data for the target temperatures can be set in advance in the temperature control module 23.

In the filament lamp 1 pertaining to this invention, when the irradiance per unit of length of each of the filaments 41, 43 that are made up of the bundled wires of each of the filament lamps 1m through 1r corresponding to the peripheral area zone Z1 becomes equivalent, the spectra too become equivalent simultaneously. Also, when the irradiance per unit of length of each of the filaments 42 made up of the a single wire of the filament lamps 1m through 1r corresponding to the center area zone Z2 becomes equivalent, the spectra also become equivalent simultaneously. Furthermore, if the power density of each of the filaments in the zone Z1 can be made larger than the power density of the filaments in the zone Z2, then the spectra can be made equivalent simultaneously. Therefore, the irradiance of the peripheral edge area can be set so that it is more intense than the center area while keeping the light absorption rates at the peripheral edge area and the center area of the article to be treated 7 equivalent and the surface of the article to be treated 7 can be heated so that the temperature distribution at the surface is uniform.

The filament lamp 1 according to the present invention has the following features: It comprises a light-emitting tube 30 and at least three filaments, 41, 42, 43, which are supplied with electrical power independently and are also located inside the light-emitting tube 30, at least one of the filaments 41, 42, 43 is made up of a single wire and at least two of the filaments are made up of bundled wires, and there is at least one filament 42, which is made up of a single wire placed between the filaments 41, 43, which are made up of bundled wires, and the rated power density of the filaments 41, 43, which are made up of bundled wires, is higher than the rated power density of the filament 42, which is made up of a single wire. As a result, the surface area per unit of length of the filaments 41, 43, which are made up of bundled wires, can be made higher than that of the filament 43, which is made up of a single wire, so that the filament temperature can be made equivalent to the filament 42 with the single wire even when the power density is raised to high levels.

In other words, in the filament lamp 1, the surface area per unit of length of the filaments 41, 43, which are made up of bundled wires, is higher than that of the filament 42 which is made up of a single wire, and by making the rated power density per unit of length of the filaments 41, 43, which are made up of bundled wires, greater than that of the filament 42, which is made up of a single wire, by the same amount as the ratios of their surface areas, the temperature of the filament 42, which is made up of a single wire (in other words, the color temperature of the light emitted from the filament 42) and the temperature of the filaments 41, 43, which are made up of bundled wires (in other words, the color temperature of the light emitted from the filaments 41, 43) can be brought into close proximity. At the same time, the spectra emitted by the filaments 41, 42 and 43, which are made up of single and bundled wires, can be brought into close proximity.

With the heat treatment device of the light irradiation type 2 in accordance with the present invention, it is possible to achieve uniform heating and rapid heating of the article to be treated 7 because several filament lamps 1 have been placed in parallel inside each lamp. Furthermore, all of the filament lamps 1 that belong to the lamp units 5, 6 are lit and operated and all of the filament temperatures (in other words, the color temperature of the light emitted from the filament) belonging to the lamp units 5, 6 are run under specific, uniform conditions. For this reason, the filaments 41, 43, 44, 45, which are made of bundled wires from the filament lamps 1k through 1t, corresponding to the peripheral edge zone Z1 will radiate energy per unit of length that is equivalent, and simultaneously, spectra that are equivalent. Also, the filament 42, which is made up of a single wire from the filament lamps 1m through 1r, corresponding to the center zone Z2 will have equivalent emitted energy per unit of length, and simultaneously, equivalent spectra. Moreover, it will be possible to make the power density of the filaments in zone Z1 greater than the power density of the filaments in zone Z2 and to simultaneously make their spectra equivalent. Therefore, it will be possible to keep the light absorption rates in the peripheral area and the center area of the article to be treated equivalent, while having a greater irradiance in the peripheral area than in the center area, allowing the article to be treated 7 to be heated so that the temperature distribution at the surface of the article to be treated 7 is uniform.

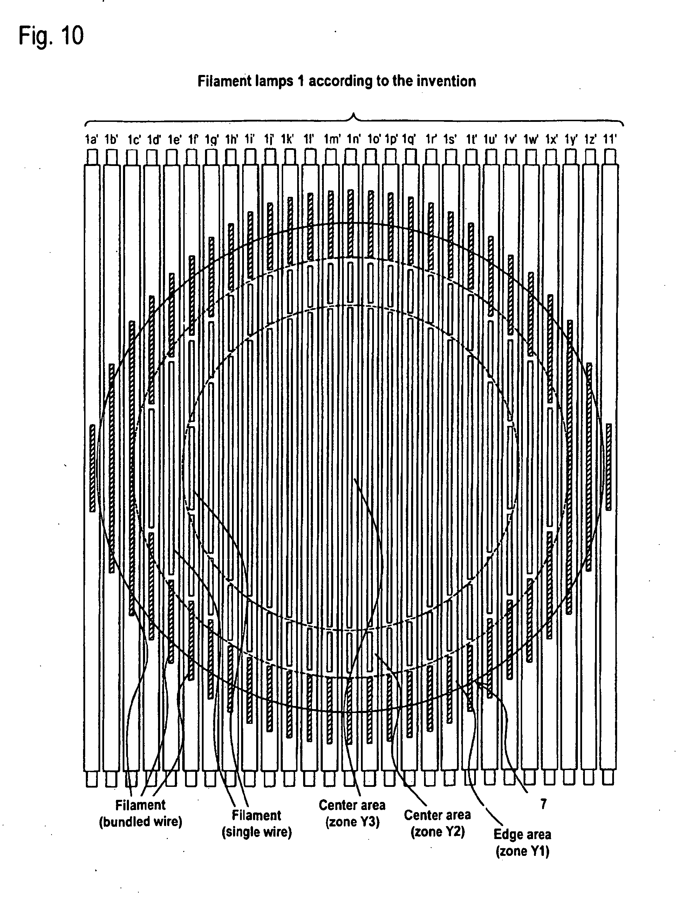

As an alternative to the arrangement in Figure 9, Figure 10 shows the article to be treated 7 in a view from the second lamp unit 6 with the first lamp unit 5 shown in Figure 2 omitted. Fig. 10 shows the second lamp unit when the heated zone of the article to be treated 7 has been divided into zone Y1 (a ring-shaped zone), corresponding to the peripheral edge area, zone Y2 (a ring-shaped zone), corresponding to the intermediate area of the article to be treated 7 and zone Y3 (disk-shaped zone), corresponding to the center area.

This lamp unit shows the filament lamps 1a' through 1c' and 1y' through 11', which are made up only of bundled wires, the filament lamps 1d' through 1e' and 1w' and 1x',
in which a single wire has been placed between two bundled wires in the filaments in the filament lamp 1 and the filament lamps 1f' through 1v', in which three single wires have been placed between two bundled wires in the filaments of the filament lamp 1.

When the article to be treated 7 is large, there are times when there is insufficient precision of uniformity in the temperature in the two zones (center area and peripheral edge area). This reason could be, for example, the effect of the flow of the process gas that is introduced into the heat-treatment space S2 (gas flow speed distribution, gas temperature, etc.) that causes localized variations on the surface of the article to be treated or because of variations in cooling of the quartz window 3, which becomes larger as the article to be treated 7 increases in size, resulting in localized variations in the heat stored in the quartz window 3. When these sorts of variation factors are present, it requires that the center area of the article to be treated 7 be further divided and that the temperature be fine-tuned.

Figure 10 shows an example of three concentric disk-shaped zones Y1, Y2 and Y3, in which an intermediate area has been added between the center area and the peripheral edge area because the article to be treated 7 is particularly large. Further dividing the center area in this manner and creating this intermediate zone Y2 makes it possible to fine-tune the temperature uniformity, which is required when the article to be treated 7 is large. Five filaments have been placed within the filament lamps 1f' through 1v', three filaments within the peripheral and center area filament lamps 1d' through 1e' and 1w' and 1x' and one filament within the filament lamps 1a' through 1c' and 1y' and 11' corresponding to the peripheral edge area. In this instance, in the filament lamp where five filaments have been placed, the three center filaments are normally made up of single wires and the two edge filaments are made up of bundled wires. The zones Y2 and Y3 are made in order to fine-tune the temperature of the center area and intermediate area as described above and, because a difference in electrical power of several percent is required for fine-tuning, no large power difference, like the power ratio between the filaments corresponding to the center area and the filaments corresponding to the peripheral edge area, is needed. Therefore, the filaments corresponding to the center area and the filaments corresponding to the peripheral edge area are made from single wires and, the temperature can be fine-tuned sufficiently by fine-tuning the power supplied from the power supply and without changing significantly the color temperature of the light emitted from the filament.

## Claims

1. A filament lamp (1), comprising:
a light emitting tube (30) in which hermetically sealed portions (31, 32) have been formed at opposite ends thereof, and
multiple filament modules in the light emitting tube (30) to which respective pairs of leads (413, 423, 433, 414, 424, 434) that supply electrical power to both ends of coiled, individual filaments (41, 42, 43) have been arranged so that they extend along a longitudinal axis of the light-emitting tube (30) and the respective leads (413, 423, 433, 414, 424, 434) are electrically connected to respective conductive components (415, 416, 435, 436, 425, 426) which are located in the hermetically sealed portions (31, 32),
the filament modules have filaments (41, 42, 43) of which at least one (42) is made from a single wire, **characterized in that** at least two filaments (41, 43) are made from bundled wires, and **in that** the filaments (41, 43) made from bundled wires are arranged at both ends of the at least one filament (42) made of a single wire.

2. The filament lamp (1) described in claim 1, wherein the bundled wires are twisted.

3. The filament lamp (1) described in claim 1 or 2, wherein the bundled wires are made up from two or four bare wires.

4. A heat treatment device of the light irradiation type (2) comprising a plurality of filament lamps (1a...1j) arranged as a set of parallel filament lamps (1) as claimed in any one of claims 1 to 3.

5. The heat treatment device of the light irradiation type (2) described in claim 4, further comprising a second set of a plurality of said filament lamps (1 k...1t) arranged in parallel, the filament lamps of said second set (1k...1t) being arranged at a right angle to the other set of filament lamps (1a...1j).

6. The heat treatment device of the light irradiation type (2) described in claim 4 or 5, wherein the filaments (42) made of single wires are located in a center zone (Z2) and wherein the filaments (41, 43) made of bundled wires are located in a peripheral zone circumferentially surrounding the center zone (Z2).

## Patentansprüche

1. Glühlampe (1), umfassend:
eine lichtdurchlässige Röhre (30), an deren entgegengesetzten Enden hermetisch verschlossene Abschnitte (31, 32) gebildet sind, und
mehrere Glühfadenmodule in der lichtdurchlässige Röhre (30), an denen jeweilige Paare von Anschlussdrähten (413, 423, 433, 414, 424, 434), die beide Enden von gewendelten einzelnen Glühfäden (41, 42, 43) mit elektrischer Energie versorgen, derart angeordnet sind, dass sie sich entlang einer Längsachse der lichtdurchlässigen Röhre (30) erstrecken und die jeweiligen Anschlussdrähte (413, 423, 433, 414, 424, 434) elektrisch mit jeweiligen leitenden Komponenten (415, 416, 435, 436, 425, 426) verbunden sind, die in den hermetisch verschlossenen Abschnitten (31, 32) angeordnet sind, wobei die Glühfadenmodule Glühfäden (41, 42, 43) aufweisen, von denen mindestens ein Glühfaden (42) aus einem einzelnen Draht gebildet ist, **dadurch gekennzeichnet, dass** mindestens zwei Glühfäden (41, 43) aus gebündelten Drähten gebildet sind, und dass die aus gebündelten Drähten gebildeten Glühfäden (41, 43) an beiden Enden des mindestens einen Glühfadens (42) angeordnet sind, der aus einem einzelnen Draht gebildet ist.

2. Glühlampe (1) nach Anspruch 1, wobei die gebündelten Drähte verdrillt sind.

3. Glühlampe (1) nach Anspruch 1 oder 2, wobei die gebündelten Drähte aus zwei oder vier blanken Drähten gebildet sind.

4. Wärmebehandlungsvorrichtung vom Lichtbestrahlungstyp (2), umfassend eine Vielzahl von Glühlampen (1a...1j), die als eine Gruppe von parallelen Glühlampen (1) nach einem der Ansprüche 1 bis 3 angeordnet sind.

5. Wärmebehandlungsvorrichtung vom Lichtbestrahlungstyp (2) nach Anspruch 4, darüber hinaus umfassend eine zweite Gruppe aus einer Vielzahl parallel angeordneter Glühlampen (1k...1t), wobei die Glühlampen der zweiten Gruppe (1k...1t) in einem rechten Winkel zu der anderen Gruppe von Glühlampen (1a...1j) angeordnet sind.

6. Wärmebehandlungsvorrichtung vom Lichtbestrahlungstyp (2) nach Anspruch 4 oder 5, wobei die aus einzelnen Drähten gebildeten Glühfäden (42) in einem mittleren Bereich (Z2) angeordnet sind und wobei die aus gebündelten Drähten gebildeten Glühfäden (41, 43) in einem peripheren Bereich angeordnet sind, der den mittleren Bereich (Z2) in Umfangsrichtung umgibt.

## Revendications

1. Lampe à incandescence (1), comprenant :
un tube transparent (30) dans lequel des parties fermées hermétiquement (31, 32) ont été formées à ses extrémités opposées, et
de multiples modules de filaments dans le tube transparent (30), vers lesquels des paires correspondantes de lignes (413, 423, 433, 414, 424, 434) fournissant de l'énergie électrique aux deux extrémités de filaments individuels en hélice (41, 42, 43) ont été disposées de façon à s'étendre le long d'un axe longitudinal du tube transparent (30) et les lignes correspondantes (413, 423, 433, 414, 424, 434) sont connectées électriquement à des composants conducteurs (415, 416, 435, 436, 425, 426) correspondants qui sont situés dans les parties fermées hermétiquement (31, 32), les modules de filaments possédant des filaments (41, 42, 43) dont au moins un (42) est fait d'un seul fil, **caractérisée en ce qu'**au moins deux filaments (41, 43) sont faits de faisceaux de fils et **en ce que** les filaments (41, 43) faits de faisceaux de fils sont disposés aux deux extrémités de l'au moins un filament (42) fait d'un seul fil.

2. Lampe à incandescence (1) selon la revendication 1, dans laquelle les faisceaux de fils sont torsadés.

3. Lampe à incandescence (1) selon la revendication 1 ou 2, dans laquelle les faisceaux de fils sont faits de deux à quatre fils nus.

4. Dispositif de traitement par la chaleur du type à irradiation lumineuse (2) comprenant une pluralité de lampes à incandescence (1a...1j) disposées dans un ensemble de lampes à incandescence (1) selon l'une des revendications 1 à 3 en parallèle.

5. Dispositif de traitement par la chaleur du type à irradiation lumineuse (2) selon la revendication 4, comprenant en outre un deuxième ensemble d'une pluralité desdites lampes à incandescence (1k...1t) montées en parallèle, les lampes à incandescence dudit deuxième ensemble (1k...1t) étant disposées perpendiculairement à l'autre ensemble de lampes à incandescence (1a...1j).

6. Dispositif de traitement par la chaleur du type à irradiation lumineuse (2) selon la revendication 4 ou 5, dans lequel les filaments (42) faits d'un seul fil sont situés dans une zone centrale (Z2) et dans lequel les filaments (41, 43) faits de faisceaux de fils sont situés dans une zone périphérique entourant la zone centrale (Z2) sur sa circonférence.
